# DEMANDE DE BREVET EUROPEEN

(11) **EP 4 823 306 A1**
(43) Date de publication de la demande: **14.10.2026**
(21) Numéro de dépôt: 26171402.6
(22) Date de dépôt: 09.04.2026
(51) Int. Cl.: H10P 14/20, H10D 8/00, H10D 8/01, H10D 30/66, H10D 62/10, H10D 62/85

(54) **PROCEDE DE FABRICATION DE COMPOSANT DE PUISSANCE AVEC MESA**

(30) Priorité: 11.04.2025 FR 2503892
(71) Demandeur: Commissariat à l'Energie Atomique et aux Energies Alternatives, 75015 Paris (FR)
(72) Inventeur: EL AMRANI, Mohammed, 38054 GRENOBLE Cedex 09 (FR); BUCKLEY, Julien, 38054 GRENOBLE Cedex 09 (FR); CHARLES, Matthew, 38054 GRENOBLE Cedex 09 (FR); KALTSOUNIS, Thomas, 38054 GRENOBLE Cedex 09 (FR); PLAZA ARGUELLO, David, 38054 GRENOBLE Cedex 09 (FR); EL RAMMOUZ, Hala, 38054 GRENOBLE Cedex 09 (FR)
(74) Mandataire: Atout PI Laplace

(57) **Abrégé**

L'invention a pour objet un procédé de fabrication d'une microstructure en mésa (10) disposée sur une première face d'un substrat de croissance (9) en un premier matériau semi-conducteur ; le procédé comprenant les étapes suivantes :
i) déposer une couche d'isolation (11), en un diélectrique, sur le substrat de croissance (9) ;
ii) fabriquer une première (13a) et une deuxième structure d'isolation (13b) séparées l'une de l'autre par une ouverture (14); les parois latérales de chaque structure d'isolation s'étendent selon un plan (P1) ayant un angle (θ) par rapport au plan de substrat (X,Y) compris entre 80° et 100° ;
iii) faire croitre ladite microstructure en mésa (10), en ledit premier matériau semi-conducteur, par épitaxie localisée dans l'ouverture (14) à partir du substrat de croissance (9) tel que la microstructure en mésa (10) soit confinée entre les deux structures d'isolation (13a, 13b) avec des parois latérales qui adhèrent à celles des structures d'isolation (13a, 13b).

## Description

Le domaine technique de l'invention est celui de l'électronique de puissance. La présente invention concerne un composant électronique de puissance et un procédé de fabrication de ce composant. Le composant peut être une diode ou un transistor, par exemple de type MOSFET (pour « metal-oxide-semiconductor field-effect transistor » en anglais).

Les composants actifs à large bande interdite, notamment les transistors planaires à haute mobilité électronique (HEMT) sur substrat de silicium, sont utilisés pour l'électronique de puissance à haut rendement et forte densité grâce à un fonctionnement à haute fréquence. Dans le contexte de l'invention, on entend par « composant actif à large bande interdite » un transistor ou une diode dans lequel la zone active (zone de formation de canal de conduction) est formée par une hétérojonction comprenant au moins une couche en un semi-conducteur choisi parmi le nitrure de gallium GaN ou le nitrure d'aluminium-gallium AlGaN ou le nitrure d'aluminium AlN. A titre d'illustration, un transistor à hétérojonction AlGaN/GaN est un type de HEMT utilisé pour les hautes fréquences et les applications de puissance. Il utilise une interface entre l'AlGaN et le GaN pour créer un gaz bidimensionnel d'électrons (2DEG) à haute mobilité. Ce gaz permet un flux rapide d'électrons, contrôlé par une grille. Le GaN supporte des tensions élevées et fonctionne à haute température.

Par ailleurs, dans une diode GaN, l'anode et la cathode se distinguent par leur rôle dans la conduction des électrons. L'anode est connectée à la couche AlGaN et reçoit les électrons en polarisation directe. La cathode est reliée à la couche GaN, où se forme un gaz d'électrons bidimensionnel (2DEG) à l'interface AlGaN/GaN. Ce 2DEG facilite la conduction des électrons. En polarisation directe, les électrons se déplacent de la cathode vers l'anode, traversant la jonction. En polarisation inverse, la barrière de potentiel bloque ce passage.

Plus particulièrement, les HEMT (High Electron Mobility Transistor en anglais) sont une catégorie spécifique de transistors avec un 2DEG conçus pour gérer des puissances élevées et des fréquences élevées tout en minimisant les pertes énergétiques, notamment dans les domaines de l'électronique de puissance. Certains transistors, dits verticaux, exploitent une configuration verticale dans laquelle la source et le drain sont situés sur deux faces opposées du transistor, ce qui leur confère plusieurs avantages en termes de robustesse face à de hautes tensions et de réduction de la surface nécessaire. De manière similaire, les diodes à structure verticale présentent deux électrodes situées sur deux faces opposées de la diode et une tension de claquage élevée sans augmenter l'encombrement par rapport à une diode horizontale. Pour obtenir ladite structure verticale, le composant actif à large bande interdite (diode ou transistor) comprend une microstructure en mésa jouant le rôle de couche active, généralement dénommée « couche de dérive » (traduction de drift layer en anglais). Dans le contexte de la microélectronique, le terme « mésa » désigne une structure surélevée d'un matériau semiconducteur par rapport à la surface d'un substrat. Cette structure surélevée est isolée électriquement des autres parties du dispositif en dessous ou autour d'elle. Une mesa peut être sous forme globalement cubique, cylindrique ou parallélépipédique rectangle ou n'importe quelle autre forme tridimensionnelle ayant une surface supérieure parallèle au plan du substrat sur lequel repose la mesa et au moins une surface latérale ayant un angle non nul avec le plan du substrat.

Dans ce contexte, un problème technique majeur est rencontré, à savoir la limitation de la tension de claquage supportée par une microstructure en mésa lorsque le composant actif vertical est soumis à des tensions supérieures à 800V. En effet, les solutions connues de croissance par épitaxie localisée permettent de réaliser des microstructures en mésa avec des parois latérales ayant un angle de l'ordre de 60° par rapport au plan du substrat. Cet angle est imposé par la direction des plans cristallographique du semi-conducteur à large bande interdite lors de la croissance par épitaxie. L'angle de 60° induit une répartition non uniforme du champ électrique dans la microstructure en mesa. En effet, un angle de 60° crée des bords inclinés qui tendent à concentrer le champ électrique en raison de la géométrie. En outre, un angle de 60° provoque des zones de forte concentration de champ électrique aux bords. Cette concentration conduit à des effets indésirables, principalement une forte limitation de la tension de claquage du composant. En raison des concentrations de champ électrique aux bords inclinés, il y a un risque accru de claquage localisé dans les régions où le champ est le plus intense. Ces points faibles peuvent rapidement causer des défaillances dans le dispositif, particulièrement lorsque le champ dépasse les seuils de tolérance du matériau semi-conducteur ou des couches isolantes.

La publication intitulée « GaN-on-Si Vertical Schottky and p-n Diodes » de "Zhang et al" propose un dispositif semi-conducteur comprenant un transistor vertical dont la zone active est formée par une mesa en GaN. La mesa présente des parois inclinées au plan du substrat suite à une opération de gravure des flancs inclinés de 60° obtenus par épitaxie. L'inconvénient de cette solution consiste en ce que la gravure des parois latérales provoque la création des défauts surfaciques dans la microstructure en mesa. Ces défauts résultants de la gravure latérale induisent une fragilité mécanique dans la structure mais aussi une perturbation du champ électrique à travers la structure. En conséquence, cela entraîne une augmentation des courants de fuite, ce qui compromet la fiabilité du composant de puissance.

Pour pallier les limitations des solutions existantes, l'invention propose un procédé de fabrication d'une microstructure en mesa présentant des parois latérales ayant un angle compris entre 80° et 100° par rapport au plan de substrat grâce à des opérations d'épitaxie localisée. Le procédé selon l'invention permet de fabriquer une telle structure sans avoir recours à des opérations de gravure des parois latérales. L'invention permet ainsi d'augmenter la tension de claquage des composants de puissance formés dans des mesas sans fragiliser la structure mécanique de la microstructure en mesa. Par ailleurs, l'invention permet de répartir le champ électrique dans la microstructure en mesa de manière plus uniforme.

De plus, le procédé de fabrication selon l'invention permet de réaliser une zone active en mesa avec une seule jonction P-N horizontale, mais également avec au moins une jonction P-N latérale inclinée.

De plus, le procédé de fabrication permet un contrôle plus précis du profil de dopage dans la microstructure en mesa en empêchant la migration des dopants des structures d'isolation, qui définissent les ouvertures de réception de l'épitaxie localisée, vers la microstructure en mesa. Ceci assure un profil de dopage uniforme dans la microstructure en mesa et permet d'améliorer la performance et la fiabilité du composant fabriqué.

L'invention a pour objet un procédé de fabrication d'une microstructure en mésa disposée sur une face d'un substrat de croissance, le substrat de croissance étant réalisé en un premier matériau semi-conducteur qui s'étend selon un plan de substrat ; le procédé comprenant les étapes suivantes :
i) déposer une couche d'isolation, en un diélectrique, sur le substrat de croissance ;
ii) fabriquer une première et une deuxième structure d'isolation séparées l'une de l'autre par une ouverture dans laquelle le substrat de croissance est découvert ; chaque structure d'isolation comprenant un corps formé par un volume non-gravé de la couche d'isolation et une enveloppe barrière aux atomes de silicium enrobant ledit corps ; les parois latérales de chaque structure d'isolation s'étendent selon un plan ayant un angle par rapport audit plan de substrat compris entre 80° et 100° ;
iii) faire croitre ladite microstructure en mésa, en ledit premier matériau semi-conducteur, par épitaxie localisée dans l'ouverture à partir du substrat de croissance tel que la microstructure en mésa soit confinée entre les deux structures d'isolation avec des parois latérales adhérant à celles des structures d'isolation.

Selon un aspect particulier de l'invention, le premier matériau semi-conducteur est choisi parmi le nitrure de gallium GaN ou le nitrure d'aluminium-gallium AlGaN ou le nitrure d'aluminium AIN.

Selon un aspect particulier de l'invention, le diélectrique de la couche d'isolation est le SiO₂.

Selon un aspect particulier de l'invention, l'étape de croissance (iii) est configurée de sorte que l'épaisseur de la microstructure en mésa soit inférieure à celle des deux structures d'isolation associées, l'épaisseur étant mesurée selon une direction perpendiculaire au plan de substrat.

Selon un aspect particulier de l'invention, l'étape de fabrication (ii) comprend les sous-étapes suivantes :
ii.1) déposer une première couche barrière aux atomes de silicium sur la couche d'isolation ;
ii.2) graver la première couche barrière et la couche d'isolation de manière à fabriquer l'ouverture délimitée par deux corps correspondant à des volumes non-gravés de la couche d'isolation ;
ii.3) déposer une deuxième couche barrière aux atomes de silicium sur les parois latérales desdits corps et sur le substrat de croissance découvert dans l'ouverture ;
ii.4) retirer la partie de la deuxième couche barrière située sur le substrat de croissance découvert dans l'ouverture par gravure de manière à découvrir le substrat de croissance dans l'ouverture.

Selon un aspect particulier de l'invention, l'étape de fabrication (ii) comprend les sous-étapes suivantes :
ii.1') graver la couche d'isolation de manière à fabriquer l'ouverture délimitée par deux corps correspondant à des volumes non-gravés de la couche d'isolation ;
ii.2') déposer une couche barrière aux atomes de silicium sur les parois supérieures et latérales desdits corps et sur le substrat de croissance découvert dans l'ouverture ;
ii.3') retirer la partie de couche barrière située sur le substrat de croissance découvert dans l'ouverture par gravure de manière à découvrir le substrat de croissance dans l'ouverture.

Selon un aspect particulier de l'invention, l'étape de croissance (iii) comprend la sous-étape suivante :
iii.1 faire croitre une couche principale en le premier matériau semi-conducteur par épitaxie localisée dans l'ouverture à partir du substrat de croissance ; une concentration volumique des dopants dans la couche principale étant inférieure à celle dans le substrat de croissance.

Selon un aspect particulier de l'invention, le premier matériau semi-conducteur de la couche principale (15) est dopé N, et l'étape de croissance (iii) comprend en outre la sous-étape suivante :
iii.2 faire croitre une couche secondaire en le premier matériau semi-conducteur dopé P par épitaxie localisée dans l'ouverture sur la couche principale pour réaliser une jonction P-N horizontale qui s'étend parallèlement au plan de substrat.

Selon un aspect particulier de l'invention, le premier matériau semi-conducteur de la couche principale est dopé N, et le procédé de fabrication d'une microstructure en mésa comprend en outre les étapes suivantes :
iv) graver partiellement la première structure d'isolation de manière à réaliser une ouverture supplémentaire délimitée par la partie non gravée de la première structure d'isolation et la microstructure en mésa ; et graver partiellement la deuxième structure d'isolation de manière à réaliser une ouverture additionnelle délimitée par la partie non gravée de la deuxième structure d'isolation et la microstructure en mésa ;
v) enrober les parois de la partie non gravée de la première structure d'isolation et les parois de la partie non gravée de la deuxième structure d'isolation par une enveloppe barrière aux atomes de silicium ;
vi) faire croitre une couche secondaire en le premier matériau semi-conducteur dopé P par épitaxie localisée dans l'ouverture supplémentaire à partir du substrat de croissance pour réaliser une première jonction P-N latérale qui s'étend le long d'un axe orthogonal au plan de substrat ; et faire croitre une couche tertiaire en le premier matériau semi-conducteur dopé P par épitaxie localisée dans l'ouverture additionnelle à partir du substrat de croissance pour réaliser une deuxième jonction P-N latérale qui s'étend le long d'un axe orthogonal au plan de substrat.

Selon un aspect particulier de l'invention, le procédé de fabrication d'une microstructure en mésa comprend en outre l'étape suivante :
vii) faire croitre une couche quaternaire en le premier matériau semi-conducteur dopé P par épitaxie localisée sur la couche principale, la couche secondaire et la couche tertiaire pour réaliser une jonction P-N horizontale qui s'étend parallèlement au plan de substrat.

L'invention concerne également un procédé de fabrication d'un composant électronique de puissance comprenant une zone active réalisée dans une microstructure en mésa sur un substrat de croissance comprenant au moins une jonction P-N qui s'étend parallèlement au plan de substrat. Le procédé de fabrication du composant comprend les étapes suivantes :
I) mettre en œuvre les étapes du procédé de fabrication d'une microstructure en mésa selon l'invention ;
II) déposer au moins une première électrode sur la microstructure en mésa ;
III) réaliser une cavité dans l'une quelconque desdites structures d'isolation débouchant jusqu'au substrat de croissance par gravure ;
IV) déposer une deuxième électrode dans la cavité.

**L'invention** concerne également un procédé de fabrication d'un composant électronique de puissance comprenant une zone active réalisée dans une microstructure en mésa sur une première face d'un substrat de croissance comprenant au moins une jonction P-N qui s'étend parallèlement au plan de substrat ; le procédé de fabrication comprenant les étapes suivantes :
I') mettre en œuvre les étapes du procédé de fabrication d'une microstructure en mésa selon l'invention ; le substrat de croissance étant disposé sur un empilement de couches formant un support ;
II') déposer au moins une première électrode sur la microstructure en mésa ;
III') retirer le support de manière à découvrir une deuxième face du substrat de croissance opposée à la première face ;
IV') déposer une deuxième électrode sur la deuxième face du substrat de croissance.

L'invention concerne également un composant électronique de puissance comprenant :
- une microstructure en mésa disposée sur une face d'un substrat de croissance en un premier matériau semi-conducteur qui s'étend selon un plan de substrat ; la microstructure en mésa étant réalisée en ledit premier matériau semi-conducteur ;
- une première structure d'isolation et une deuxième structure d'isolation ; chaque structure d'isolation comprenant :
   ∘ un corps en un diélectrique ;
   ∘ et une enveloppe barrière aux atomes de silicium enrobant ledit corps ;
   la microstructure en mésa étant confinée entre les deux structures d'isolation avec des parois latérales adhérant à celle des structures d'isolation ; les parois latérales de chacune des structures d'isolation s'étendant selon un plan ayant un angle par rapport audit plan de substrat compris entre 80° et 100°.

Notamment, la première et la deuxième structure d'isolation sont séparées l'une de l'autre par une ouverture dans laquelle le substrat de croissance est découvert, et la microstructure en mésa étant réalisée par épitaxie localisée dans l'ouverture à partir du substrat de croissance.

Selon un aspect particulier de l'invention, la microstructure en mésa comprend :
∘ une première couche en le premier matériau semi-conducteur dopée N disposée sur le substrat de croissance ;
∘ une deuxième couche en le premier matériau semi-conducteur dopée P disposée sur la première couche de manière à former une jonction P-N horizontale qui s'étend parallèlement au plan de substrat.

Selon un aspect particulier de l'invention, la microstructure en mésa comprend :
∘ une première couche en le premier matériau semi-conducteur dopée N disposée sur le substrat de croissance ;
∘ une deuxième couche en le premier matériau semi-conducteur dopé P disposée sur substrat de croissance et confinée entre la première structure d'isolation et la première couche de manière à réaliser une première jonction P-N latérale qui s'étend le long d'un axe orthogonal au plan de substrat ;
∘ une troisième couche en le premier matériau semi-conducteur dopé P sur le substrat de croissance et confinée entre la deuxième structure d'isolation et la première couche de manière à réaliser une deuxième jonction P-N latérale qui s'étend le long d'un axe orthogonal au plan de substrat ;
∘ une quatrième couche en le premier matériau semi-conducteur dopée P disposée sur au moins la première couche de manière à former une jonction P-N horizontale qui s'étend parallèlement au plan de substrat.

D'autres caractéristiques et avantages de la présente invention apparaîtront mieux à la lecture de la description qui suit en relation aux dessins annexés suivants.
La figure 1 illustre l'organigramme d'un procédé de fabrication d'une microstructure en mésa selon un premier mode de réalisation de l'invention.
La figure 2a illustre la structure obtenue à l'issue de la première étape du procédé de fabrication d'une microstructure en mésa selon le premier mode de réalisation de l'invention.
Les figures 2b à 2e illustrent les sous étapes formant la deuxième étape du procédé de fabrication d'une microstructure en mésa selon le premier mode de réalisation de l'invention.
La figure 2f illustre la structure obtenue à l'issue de la troisième étape du procédé de fabrication d'une microstructure en mésa selon le premier mode de réalisation de l'invention.
La figure 3 illustre l'organigramme d'un procédé de fabrication d'une microstructure en mésa selon un deuxième mode de réalisation de l'invention.
La figure 4a illustre la structure obtenue à l'issue de la première étape du procédé de fabrication d'une microstructure en mésa selon le deuxième mode de réalisation de l'invention.
Les figures 4b à 4d illustrent les sous étapes formant la deuxième étape du procédé de fabrication d'une microstructure en mésa selon le deuxième mode de réalisation de l'invention.
La figure 4e illustre la structure obtenue à l'issue de la troisième étape du procédé de fabrication d'une microstructure en mésa selon le deuxième mode de réalisation de l'invention.
La figure 5 illustre l'organigramme d'un procédé de fabrication d'une microstructure en mésa selon un troisième mode de réalisation de l'invention.
La figure 6a illustre la structure obtenue à l'issue des trois premières étapes du procédé de fabrication d'une microstructure en mésa selon le troisième mode de réalisation de l'invention.
La figure 6b illustre la structure obtenue à l'issue de la quatrième étape du procédé de fabrication d'une microstructure en mésa selon le troisième mode de réalisation de l'invention.
La figure 6c illustre la structure obtenue à l'issue de la cinquième étape du procédé de fabrication d'une microstructure en mésa selon le troisième mode de réalisation de l'invention.
La figure 6d illustre la structure obtenue à l'issue de la sixième étape du procédé de fabrication d'une microstructure en mésa selon le troisième mode de réalisation de l'invention.
La figure 6e illustre la structure obtenue à l'issue de la septième étape du procédé de fabrication d'une microstructure en mésa selon le troisième mode de réalisation de l'invention.
La figure 7a illustre l'organigramme d'un premier procédé de fabrication d'un composant de puissance selon l'invention.
La figure 7b illustre une vue en coupe d'un premier exemple d'une diode obtenue par le premier procédé de fabrication de composant selon l'invention.
La figure 7c illustre une vue en coupe d'un premier exemple d'un transistor obtenu par le premier procédé de fabrication de composant selon l'invention.
La figure 7d illustre une vue en coupe d'un second exemple d'une diode obtenue par le premier procédé de fabrication de composant selon l'invention.
La figure 7e illustre une vue en coupe d'un second exemple d'un transistor obtenu par le premier procédé de fabrication de composant selon l'invention.
La figure 8a illustre l'organigramme d'un second procédé de fabrication d'un composant de puissance selon l'invention.
La figure 8b illustre une vue en coupe d'un premier exemple d'une diode obtenue par le second procédé de fabrication de composants l'invention.
La figure 8c illustre une vue en coupe d'un premier exemple de transistor obtenue par le second procédé de fabrication de composants l'invention.
La figure 8d illustre une vue en coupe d'un second exemple d'une diode obtenue par le second procédé de fabrication de composants l'invention.
La figure 8e illustre une vue en coupe d'un second exemple de transistor obtenue par le second procédé de fabrication de composants l'invention.

Sur les figures d'illustration de l'invention, l'horizontal est représenté par des directions X et Y d'un repère orthogonal (X,Y,Z). La direction Z de ce repère orthogonal représente la direction verticale. Par la suite, les termes tels que « supérieur », « inférieur », « au-dessus », « en dessous », « haut » et « bas » sont définis par rapport à cette direction Z. Les termes « gauche » et « droite » sont définis par rapport à la direction X. Les termes « avant » et « arrière » sont définis par rapport à la direction Y. Par la suite, le terme « épaisseur » désigne l'épaisseur maximale d'un élément selon la direction Z, dite direction d'empilement. Le terme « largeur » désigne la dimension d'une couche selon la direction X.

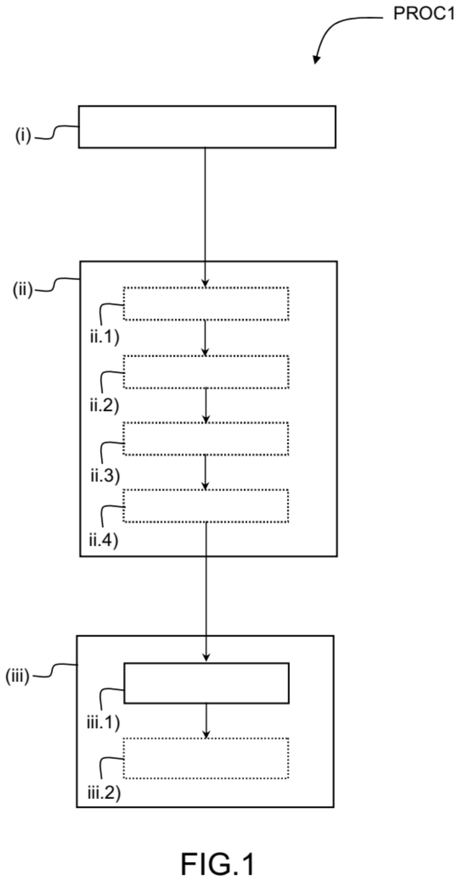

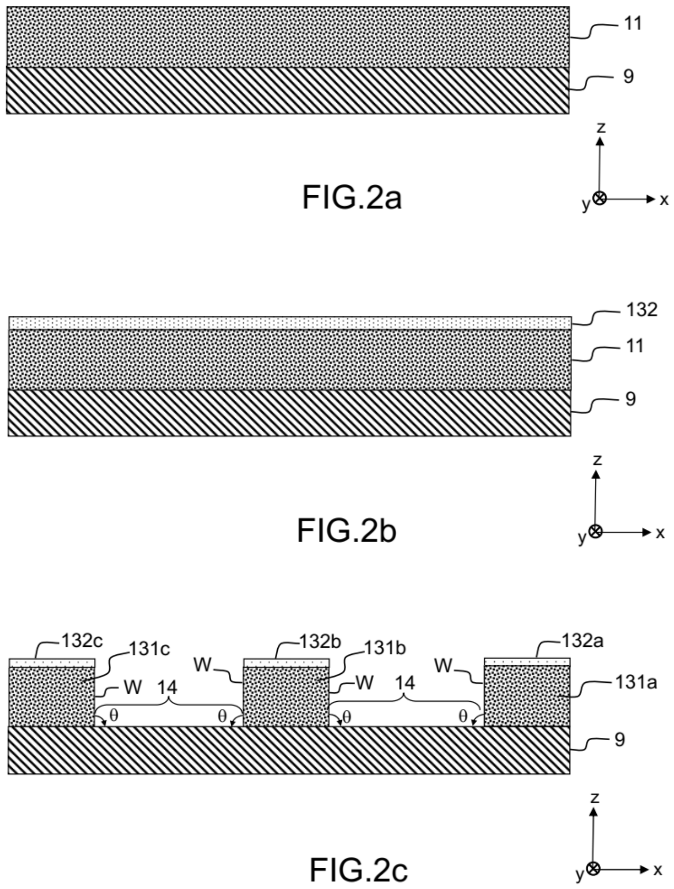

La figure 1 illustre l'organigramme du procédé PROC1 de fabrication d'une microstructure en mésa selon un premier mode de réalisation de l'invention. Les figures 2a à 2f illustrent les étapes du procédé PROC1 selon l'invention.

La première étape (i) consiste à déposer une couche d'isolation 11, en un diélectrique comprenant du silicium, sur un substrat de croissance 9 épitaxiale. La structure intermédiaire obtenue à l'issue de la première étape (i) est illustrée sur la figure 2a. La couche d'isolation 11 joue le rôle d'un masque dur qui résiste aux étapes ultérieures d'épitaxie à haute température, typiquement supérieure à 1000°C. La couche d'isolation 11 est réalisée en SiO2 ou en SiN . L'épaisseur de la couche d'isolation 11 est supérieure à l'épaisseur prévue pour la couche épitaxiale de GaN. Le dépôt de la couche d'isolation 11 est réalisé par un « dépôt chimique en phase vapeur organo-métallique » (MOCVD pour metal organic chemical vapor deposition) ou par « épitaxie en faisceau moléculaire » (MBE pour molecular beam epitaxy). Le substrat de croissance 9 est une couche réalisée en un matériau semiconducteur à large bande interdite tel que le nitrure de gallium GaN ou le nitrure d'aluminium-gallium AlGaN ou le nitrure d'aluminium AlN. De préférence, le substrat de croissance 9 est fortement dopé N. A titre d'exemple, le substrat de croissance 9 est une couche en GaN avec une concentration de dopants N en silicium comprise entre 5.10¹⁸ et 5.10²⁰ cm⁻³, de préférence égale à 5.10¹⁸ cm⁻³. Le substrat de croissance 9 joue un triple rôle : Premièrement, le contrôle de la structure cristalline dans la microstructure en mesa qui sera fabriquée par épitaxie. Deuxièmement, une couche de contact électrique grâce au fort dopage introduit. Troisièmement, un support mécanique sur lequel reposera la microstructure en mesa. Dans le contexte de la description de l'invention, on entend par « substrat de croissance épitaxiale », la couche supérieure à partir de laquelle la croissance épitaxiale se produira. Avantageusement, le substrat de croissance 9 est disposé directement ou indirectement sur un substrat massif en silicium ou sur un empilement de couches formé sur un substrat massif en silicium. Nous nous limitons à illustrer le substrat de croissance 9 dans la suite des figures pour simplifier la présentation. Cela permet d'intégrer le procédé de fabrication dans des chaines de production microélectronique plus mature technologiquement.

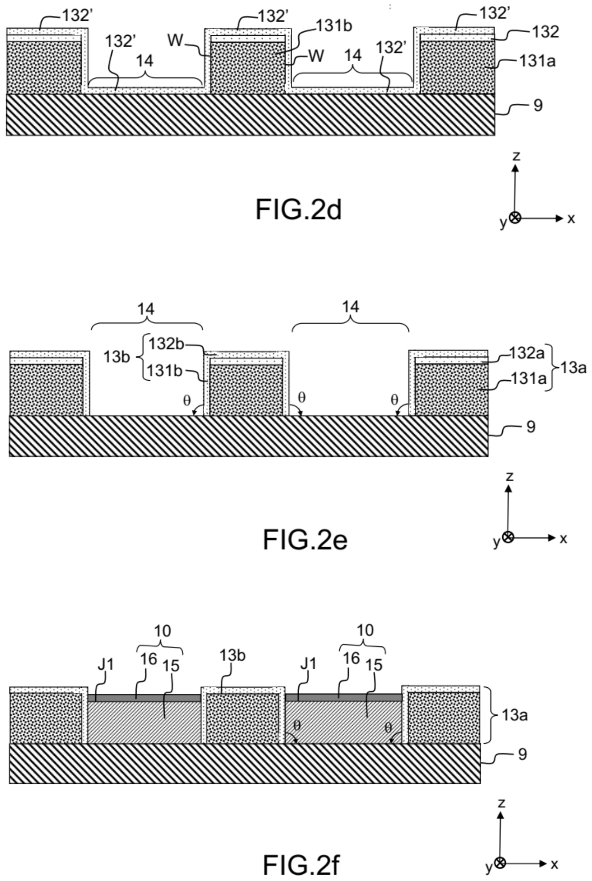

La deuxième étape (ii) consiste à fabriquer au moins une première structure d'isolation 13a et une deuxième structure d'isolation 13b séparés l'une de l'autre par une ouverture 14 dans laquelle le substrat de croissance 9 est découvert. La structure intermédiaire obtenue à l'issue de la deuxième étape (ii) est illustrée sur la figure 2e. A titre d'exemple illustratif et non limitatif, on illustre la fabrication de trois structures d'isolation 13a, 13b et 13c formant deux ouvertures adjacentes 14. Chaque structure d'isolation 13a, 13b ; 13c comprend, respectivement, un corps en diélectrique 131a, 131b, 131c formé par un volume non-gravé de la couche d'isolation 11. Chaque structure d'isolation 13a, 13b ; 13c comprend en outre une enveloppe 132a, 132b, 132c barrière aux atomes du silicium, par exemple en alumine Al₂O₃ ou en nitrure de bore hexagonal (h-BN, ou nitrure de bore en structure graphite), ou en graphene. Chaque enveloppe 132a, 132b, 132c enrobe le corps de la structure d'isolation associée. Pour chaque structure d'isolation, l'enveloppe recouvre au moins les surfaces latérales W du corps de ladite structure d'isolation. De manière préférentielle, l'enveloppe recouvre toutes les surfaces externes du corps en diélectrique de la structure d'isolation associée. L'enveloppe 132a, 132b, 132c présente un avantage essentiel dans la mise en œuvre de l'invention. En effet, l'enveloppe de chaque structure d'isolation permet de protéger la microstructure en mésa selon l'invention de la diffusion d'atomes de silicium provenant du corps de la structure d'isolation lors de sa croissance par épitaxie. La diffusion d'atomes de silicium dans la microstructure en mésa induit un profil de dopage non-uniforme avec des zones fortement dopées par rapport au reste de la microstructure. Ces zones provoquent une perturbation du champ électrique à travers la microstructure en mesa et réduisent ainsi la fiabilité d'un composant dont la zone active se retrouve dans la microstructure en mesa. Ainsi, l'enveloppe de chaque structure d'isolation assure un dopage uniforme qui améliore la fiabilité du composant en améliorant la tension de claquage supportée par la microstructure en mésa. L'enveloppe 132a, 132b, 132c présente une épaisseur supérieure ou égale à 10 nm, idéalement supérieure à 40 nm.

La deuxième étape (ii) est réalisée de manière à obtenir des parois latérales W de chaque structure d'isolation qui s'étendent selon un plan ayant un angle θ par rapport audit plan de substrat (X,Y) compris entre 80° et 100°. De manière préférentielle, l'angle θ est sensiblement égal à 90°, et dans ce cas les parois latérales W sont sensiblement orthogonales au plan du substrat de croissance 9. Par exemple, l'angle θ est égal à 90°.

Dans le procédé PROC1 selon le premier mode de réalisation de l'invention, la deuxième étape (ii) est mise en œuvre par les sous-étapes illustrées par les figures 2b à 2e. La première sous étape (ii.1), illustrée par la figure 2b, consiste à déposer une première couche 132 barrière aux atomes du silicium, par exemple en Al₂O₃ ou en nitrure de bore hexagonal (h-BN, ou nitrure de bore en structure graphite), ou en graphene, sur la couche d'isolation 11. La première couche barrière 132 présente une épaisseur d'au moins 10 nm. Le dépôt de la couche barrière 132 est réalisable par « dépôt chimique en phase vapeur » (CVD pour Chemical Vapor Deposition) ou par « dépôt par couches atomiques » (ALD pour Atomic Layer Deposition) ou par « épitaxie en faisceau moléculaire » (MBE pour molecular beam epitaxy).

La deuxième sous étape (ii.2), illustrée par la figure 2c, consiste à graver l'empilement formé par la première couche barrière 132 et la couche d'isolation 11 de manière à obtenir les ouvertures 14. Dans l'exemple illustré, on obtient une première ouverture 14 délimitée par deux corps 131a, et 131b correspondant à des volumes non-gravés de la couche d'isolation 13 et une deuxième ouverture 14 délimitée par deux corps 131b, et 131c correspondant à des volumes non-gravés de la couche d'isolation 13. Seule la surface supérieure de chaque corps non gravé est recouverte par une partie non gravée de la première couche barrière 132. La largeur de chaque ouverture 14 est comprise entre 5µm 500 µm. La gravure est réalisée de manière locale dans l'emplacement des ouvertures 14 jusqu'à découvrir la surface supérieure du substrat de croissance 9 dans chacune des ouvertures 14. De manière préférentielle, la sous-étape (ii.2) est réalisée par « gravure ionique réactive » (RIE pour Reactive Ion Etching) qui utilise un plasma de gaz pour graver de manière anisotrope la couche barrière 132 et la couche d'isolation 11 offrant un meilleur contrôle pour la fabrication de motifs fins. La gravure anisotropie permet d'obtenir des parois latérales des corps 131a,131b,131c ayant un angle θ par rapport audit plan de substrat (X,Y) compris entre 80° et 100°, par exemple sensiblement égal à 90° de manière avantageuse, et par exemple égal à 90°.

La troisième sous étape (ii.3), illustrée par la figure 2d, consiste à déposer une deuxième couche barrière 132' barrière aux atomes du silicium, par exemple en Al₂O₃ ou en nitrure de bore hexagonal (h-BN, ou nitrure de bore en structure graphite), ou en graphene, sur les parois latérales W desdits corps 131a, 131b, 132c et sur le substrat de croissance 9 découvert dans les ouvertures 14. La deuxième couche barrière 132' présente une épaisseur d'au moins 10 nm. Le dépôt de la deuxième couche barrière 132' est réalisable par « dépôt chimique en phase vapeur » (CVD pour Chemical Vapor Deposition) ou par « dépôt par couches atomiques » (ALD pour Atomic Layer Deposition) ou par « épitaxie en faisceau moléculaire » (MBE pour molecular beam epitaxy).

La quatrième sous-étape (ii.4), illustrée sur la figure 2e, consiste à retirer les parties de la deuxième couche barrière 132' située sur le substrat de croissance 9 découvert dans les ouvertures 14 par gravure de manière à découvrir à nouveau le substrat de croissance 9 dans les ouvertures. Avantageusement, cette sous-étape est réalisée par « gravure ionique réactive » permettant de préserver les parties de la deuxième couche barrière 132' disposée sur les parois latérales W des corps 131a, 131b, 132c. On obtient ainsi, trois structures d'isolation 13a, 13b, 13c chacune formée d'un corps en diélectrique enrobé d'une enveloppe 132a, 132b, 132c suffisamment épaisse pour empêcher la migration des atomes de silicium ou d'autres dopants dans la microstructure en mesa à fabriquer.

La troisième étape (iii) consiste à faire croitre une microstructure en mésa 10 par épitaxie localisée dans chaque ouverture 14 à partir du substrat de croissance 9. La structure obtenue à l'issue de la troisième étape (iii) est illustrée sur la figure 2f. De manière générale, la troisième étape (iii) consiste à faire croitre par épitaxie localisée la microstructure en mesa 10 comprenant au moins une couche en un matériau semi-conducteur choisi parmi le nitrure de gallium GaN ou le nitrure d'aluminium-gallium AlGaN ou le nitrure d'aluminium AIN. La mise en œuvre de la troisième étape est réalisée principalement par épitaxie par jets moléculaires (MBE) ou par épitaxie en phase vapeur organo-métallique (MOCVD).

En particulier, la croissance de la microstructure en mésa 10 est réalisée par épitaxie localisée dans l'ouverture 14 directement à partir du substrat de croissance 9. En particulier, directement à partir de la portion découverte du substrat de croissance, c'est-à-dire à partir de la face du substrat 9. En d'autres termes, la microstructure mésa 10, ainsi fabriquée, présente une face, dite face inférieure, disposée directement sur la face du substrat 9. En d'autres termes, la face inférieure de la microstructure mésa adhère au substrat 9. On dit également que la face inférieure de la microstructure mésa est en contact mécanique, ou encore est directement en contact, avec la face du substrat 9.

De préférence, le substrat de croissance 9 est réalisé dans un premier matériau semi-conducteur (par exemple du GaN, AlGaN, AlN) et la microstructure en mésa 10 est réalisée en un deuxième matériau (par ex, GaN, ou AlGaN ou AIN). Les premier et deuxième matériaux peuvent être différents, de préférence identiques pour faciliter la fabrication de la microstructure en mésa.

A titre d'exemple illustratif et non limitatif, la microstructure en mesa 10 comprend un empilement de deux couches en GaN qui forment une jonction P-N horizontale (parallèle au plan du substrat (X,Y)). Dans ce cas, la troisième étape (iii) comprend une première sous-étape (iii.1) qui consiste à faire croitre une première couche 15 en GaN dopé N par épitaxie localisée dans l'ouverture 14 à partir du substrat de croissance 9. Le dopage en silicium dans le GaN est contrôlé lors de l'épitaxie de manière à obtenir une concentration volumique des dopants dans la première couche 15 inférieure à celle dans le substrat de croissance 9, par exemple égale à 1.10¹⁶ atomes/cm³. La croissance par épitaxie localisée dans l'ouverture 14 engendre que la première couche 15 en GaN croit progressivement tel que ses parois latérales épousent les parois latérales W des structures d'isolations 13a, 13b qui délimitent l'ouverture associée 14. Ainsi, la première couche 15 présente des parois latérales formant un angle supplémentaire à l'angle θ par rapport au plan du substrat ; donc la première couche 15 présente des parois latérales ayant un angle compris entre 80° et 100° avec le plan substrat. La troisième étape (iii) comprend ensuite une deuxième sous-étape (iii.2) qui consiste à faire croitre une deuxième couche 16 en ledit premier matériau semi-conducteur (GaN dans ce cas) dopé P par épitaxie localisée dans l'ouverture 14 sur la surface supérieure de la première couche 15. On obtient ainsi une microstructure en mésa 11 formée par les deux couches superposées 15,16 qui forment une jonction P-N horizontale J1 qui s'étend parallèlement au plan de substrat (X,Y). De manière similaire, l'épitaxie localisée dans l'ouverture 14 permet en croissance progressive de la deuxième couche 16 telle que ses parois latérales épousent les parois latérales W des structures d'isolation 13a, 13b qui délimitent l'ouverture associée 14. On obtient ainsi, une microstructure en mésa 10 confinée entre les deux structures d'isolation 13a, 13b avec des parois latérales qui adhèrent à celles des structures d'isolation grâce à l'épitaxie localisée. Ainsi, l'angle θ obtenu des parois de la microstructure en mesa 10 par rapport au plan de substrat permet d'augmenter la tension de claquage tolérée par la microstructure en mesa par rapport aux solutions connues pour atteindre des tensions allant au-delà de 1200V. De plus, le procédé selon l'invention permet de fabriquer une microstructure en mesa avec des parois latérales formant un angle compris entre 80° et 100°, et idéalement 90° sans avoir recours à une opération de gravure des parois latérales de la mesa. L'élimination de la gravure des flancs latéraux de la microstructure en mesa permet d'éliminer des défauts surfaciques dans la microstructure en mesa par rapport aux solutions connues. Cela améliore la fiabilité mécanique et électrique de la microstructure en mesa et ainsi des composants de puissance qui comprennent une telle microstructure.

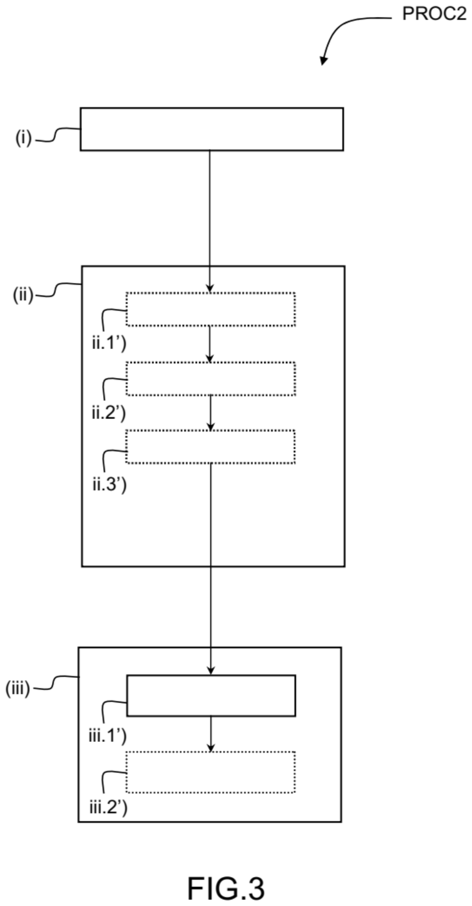

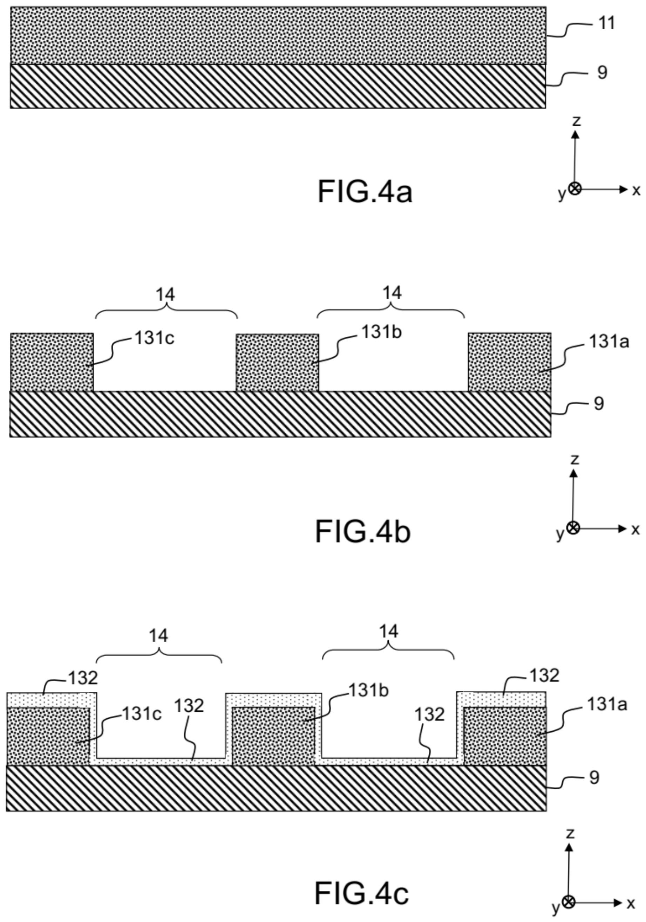

La figure 3 illustre l'organigramme du procédé PROC2 de fabrication d'une microstructure en mésa selon un deuxième mode réalisation de l'invention. Les figures 4a à 4e illustrent les étapes du procédé PROC2.

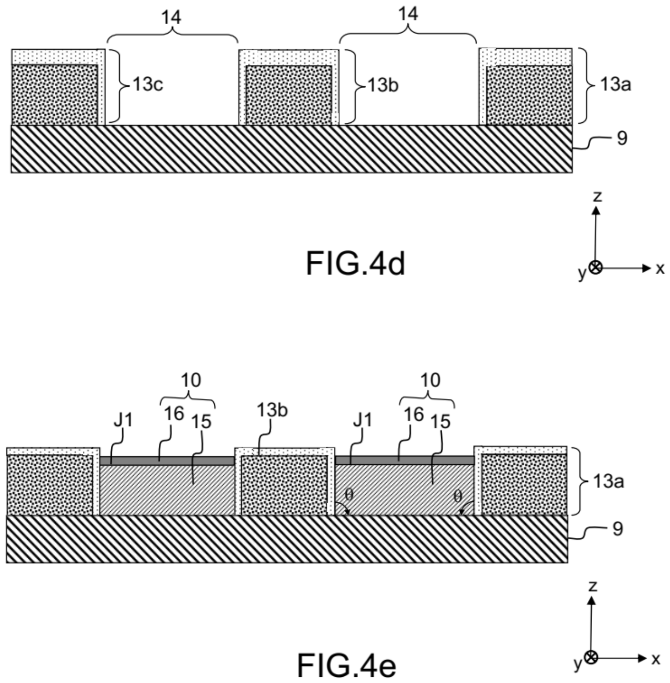

Le procédé PROC2 se distingue du procédé PROC1 par les sous-étapes de la deuxième étape (ii). Les caractéristiques et les avantages détaillés pour le procédé PROC1 selon le premier mode de réalisation restent valables pour le procédé PROC2 selon le deuxième mode de réalisation. La première étape (i) du procédé PROC2 est identique à la première étape (i) du procédé PROC1. La structure intermédiaire obtenue à l'issue de la première étape (i) est illustrée sur la figure 4a. De manière similaire, la deuxième étape (ii) consiste à fabriquer au moins une première structure d'isolation 13a et une deuxième structure d'isolation 13b séparées l'une de l'autre par une ouverture 14 dans laquelle le substrat de croissance 9 est découvert. La structure intermédiaire obtenue à l'issue de la deuxième étape (ii) est illustrée sur la figure 4d.

Dans le procédé PROC2 selon le deuxième mode de réalisation de l'invention, la deuxième étape (ii) est mise en œuvre par les sous-étapes illustrées par les figures 4b à 4d.

La première sous-étape (ii.1'), illustrée par la figure 4b, consiste à graver la première la couche d'isolation 11 de manière à obtenir les ouvertures 14. Dans l'exemple illustré, on obtient une première ouverture 14 délimitée par deux corps 131a, et 131b correspondant à des volumes non-gravés de la couche d'isolation 13 et une deuxième ouverture 14 délimitée par deux corps 131b, et 131c correspondant à des volumes non-gravés de la couche d'isolation 13. La gravure est réalisée de manière locale dans l'emplacement des ouvertures 14 jusqu'à découvrir la surface supérieure du substrat de croissance 9 dans chacune des ouvertures 14. De manière préférentielle, la première sous-étape (ii.1') est réalisée par « gravure ionique réactive » (RIE pour Reactive Ion Etching) qui utilise un plasma de gaz pour graver de manière anisotrope la couche d'isolation 11 offrant un meilleur contrôle pour la fabrication de motifs fins. La gravure anisotropie permet d'obtenir des parois latérales des corps 131a, 131b, 131c ayant un angle θ par rapport au plan de substrat (X,Y) compris entre 80° et 100° et sensiblement égal à 90° de manière avantageuse, par exemple égal à 90°.

La deuxième sous-étape (ii.2'), illustrée par la figure 4c, consiste à déposer une première couche barrière 132 aux atomes du silicium, par exemple en Al₂O₃ ou en nitrure de bore hexagonal (h-BN, ou nitrure de bore en structure graphite), ou en graphène, sur la structure intermédiaire de la sous-étape précédente. La première couche barrière 132 présente une épaisseur d'au moins 20 nm. Le dépôt de la couche barrière 132 est réalisable par « dépôt chimique en phase vapeur » (CVD pour Chemical Vapor Deposition) ou par « dépôt par couches atomiques » (ALD pour Atomic Layer Deposition) ou par « épitaxie en faisceau moléculaire » (MBE pour molecular beam epitaxy).

La troisième sous-étape (ii.3'), illustrée sur la figure 4d, est identique à la quatrième sous-étape (ii.4) du procédé PROC1 selon le premier mode de réalisation.

La troisième étape (iii) du procédé PROC2 est identique à la troisième étape (iii) du procédé PROC1. La structure intermédiaire obtenue à l'issue de la troisième étape (iii) est illustrée sur la figure 4e.

Le procédé PROC2 selon le deuxième mode de réalisation permet de fabriquer la microstructure en mesa 10 selon l'invention avec moins d'étapes de dépôt de la couche barrière par rapport au procédé PROC1 selon le premier mode de réalisation.

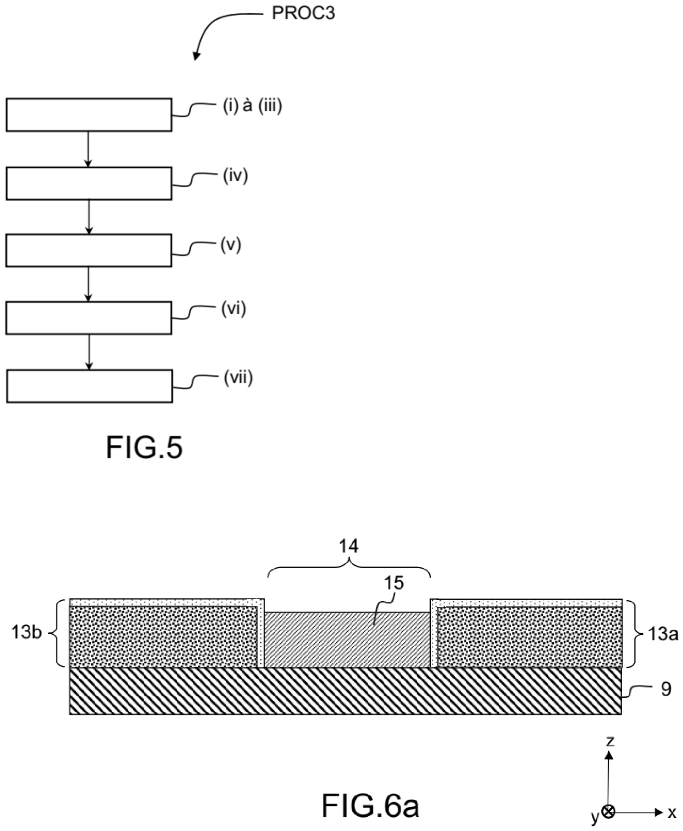

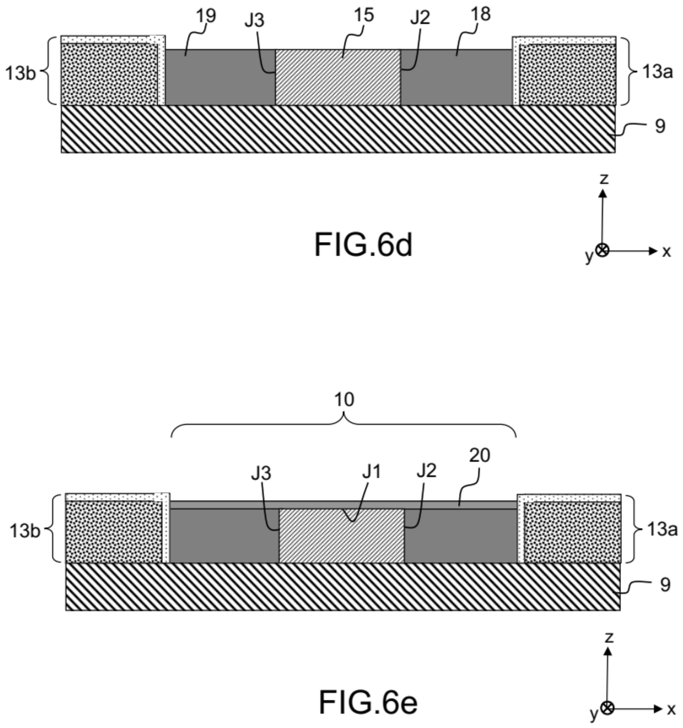

La figure 3 illustre l'organigramme du procédé PROC3 de fabrication d'une microstructure en mésa 10 selon un troisième mode de réalisation de l'invention. Les figures 6a à 6e illustrent les étapes du procédé PROC3. Le procédé PROC3 de fabrication commence par la mise en œuvre de toutes les étapes de l'un des procédés PROC1 ou PROC2 pour fabriquer une microstructure en mesa 10 selon l'invention comprenant la première couche 15 dopée N telle que décrite dans les modes de réalisation précédents. La structure obtenue des étapes (i) à (iii) est illustrée sur la figure 6a.

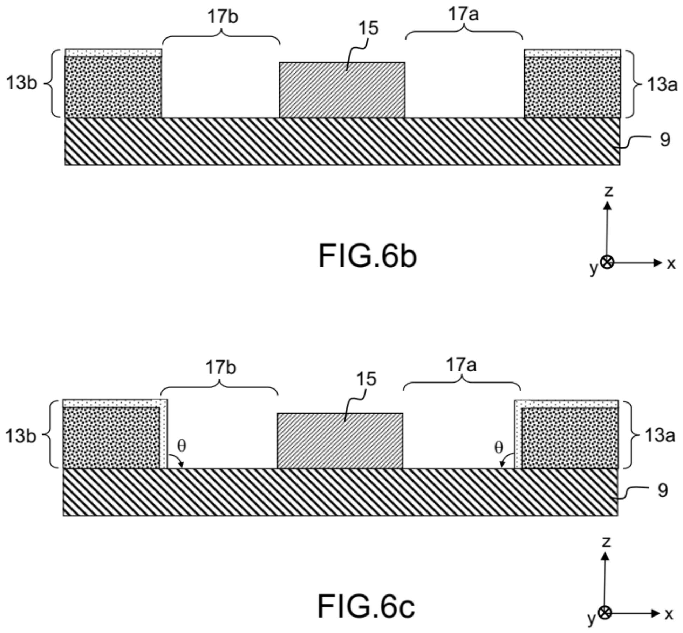

Le procédé PROC3 comprend en outre une quatrième étape (iv) qui consiste à graver partiellement la première structure d'isolation 13a de manière à réaliser une ouverture supplémentaire 17a délimitée par la partie non gravée de la première structure d'isolation 13a et la microstructure en mésa 10. De manière simultanée, la quatrième étape (iv) consiste en outre à graver partiellement la deuxième structure d'isolation 13b de manière à réaliser une ouverture additionnelle 17b délimitée par la partie non gravée de la deuxième structure d'isolation 13b et la microstructure en mésa 10. La largeur selon l'axe Y de chacune des ouvertures 17a, 17b est comprise entre 5µm et 100 µm. La gravure est réalisée par « gravure ionique réactive » pour graver de manière anisotrope les deux structures d'isolation 13a, 13b. La structure obtenue à l'issue de la quatrième étape (iv) est illustrée sur la figure 6b. La partie non gravée de chaque structure d'isolation 13a, 13b présente un angle θ par rapport au plan de substrat (X,Y) compris entre 80° et 100°, de préférence égal à 90°.

Le procédé PROC3 comprend en outre une cinquième étape (v) qui consiste à enrober les parois de la partie non gravée de la première structure d'isolation 13a et les parois de la partie non gravée de la deuxième structure d'isolation 13b par une enveloppe barrière aux atomes du silicium, par exemple en Al₂O₃ ou en nitrure de bore hexagonal (h-BN, ou nitrure de bore en structure graphite), ou en graphène. « dépôt chimique en phase vapeur » (CVD pour Chemical Vapor Deposition) ou par « dépôt par couches atomiques » (ALD pour Atomic Layer Deposition). L'enveloppe déposée présente une épaisseur supérieure ou égale à 10 nm. La structure obtenue à l'issue de la cinquième étape (v) est illustrée sur la figure 6c.

Le procédé PROC3 comprend en outre une sixième étape (vi) qui consiste à faire croitre une deuxième couche 18 en le premier matériau semi-conducteur (en GaN dans l'exemple illustré) par épitaxie localisée dans la deuxième ouverture 17a à partir du substrat de croissance 9. La deuxième couche 18 est dopé P lors de l'épitaxie localisée. A titre d'exemple, le substrat de croissance 9 est une couche en GaN avec une concentration de dopants P en magnésium comprise entre 10¹⁸ et 10²⁰, de préférence égale à 4.10¹⁸ atomes/cm3. La croissance par épitaxie localisée dans l'ouverture 17a engendre que la deuxième couche 18 en GaN croit progressivement tel que ses parois latérales épousent les parois latérales de la structure d'isolation 13a et de la première couche 15 qui délimitent l'ouverture associée 17a. Ainsi, la deuxième couche 18 présente des parois latérales formant un angle supplémentaire à l'angle θ par rapport au plan du substrat ; qui est donc compris entre 80° et 100° avec le plan substrat. La deuxième couche 18 dopée P présente une interface de contact direct avec la première couche 15 dopée N de manière à réaliser une première jonction P-N latérale J2 qui s'étend le long d'un axe orthogonal au plan de substrat X,Y. De manière identique, la sixième étape (vi) comprend une croissance d'une une troisième couche 19 en le premier matériau semi-conducteur dopé P par épitaxie localisée dans la troisième ouverture 17b à partir du substrat de croissance 9. La troisième couche 19 permet de réaliser une deuxième jonction P-N latérale J3 qui s'étend le long d'un axe orthogonal au plan de substrat (X,Y). La troisième couche 19 présente des parois latérales formant un angle compris entre 80° et 100° avec le plan du substrat. La structure obtenue à l'issue de la sixième étape (vi) est illustrée sur la figure 6d. L'épaisseur de la deuxième couche 18 et de la troisième couche 19 sont égales à l'épaisseur de la première couche 15 de manière à obtenir une surface supérieure plane formée par les trois couches 15, 18, 19.

Le procédé PROC3 comprend en outre une septième étape (vii) qui consiste à faire croitre une quatrième couche 20 en le premier matériau semi-conducteur, dopée P par épitaxie localisée, sur la surface supérieure des couches 15, 18, 19. L'interface entre la première couche 15 dopée N et la quatrième couche 20 dopée P permet de réaliser une jonction P-N horizontale J1 qui s'étend parallèlement au plan de substrat (X,Y). La quatrième couche 10 croit progressivement tel que ses parois latérales épousent les parois latérales des structures d'isolation 13a, 13b.

On obtient ainsi, une microstructure en mesa 10 avec des parois formant un angle compris entre 80° et 100° avec la surface du plan de substrat 9 ce qui permet d'augmenter la tension de claquage tolérée par la microstructure par rapport aux solutions connues, sans avoir recours à une opération de gravure des flancs latéraux de la microstructure en mesa. Avantageusement, le procédé PROC3 permet de réaliser une microstructure en mesa 10 avec deux jonctions P-N latérales J2, J3 et une jonction J1 horizontale P-N ce qui offre une performance supérieure en termes de gestion de puissance, de réduction des pertes et de gestion thermique dans le contexte d'un composant électronique de puissance. Plus particulièrement, ladite microstructure en mesa selon l'invention avec trois jonctions permet de réduire la résistance à l'état passant, ce qui réduit les pertes de conductions dans les dispositifs de puissance tout en gardant une haute tension de claquage.

Le confinement de la microstructure en mesa selon l'un quelconque des modes de réalisation de l'invention permet en outre de protéger ladite microstructure des chocs mécaniques lors de la manipulation de la tranchée (wafer en anglais) lors des différentes étapes du procédé de fabrication dans une chaine de production microélectronique.

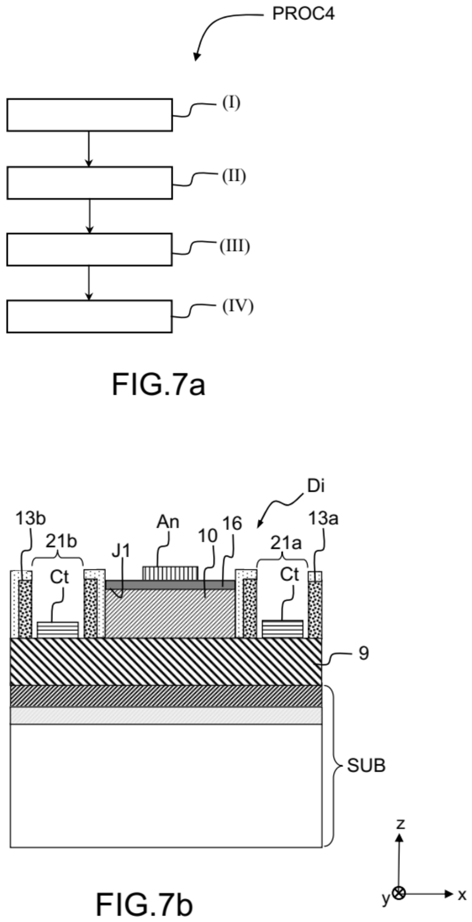

La figure 7a illustre l'organigramme d'un premier procédé de fabrication PROC4 d'un composant de puissance selon l'invention. Le composant de puissance peut être une diode ou un transistor de puissance. Le composant de puissance comprend une zone active formée dans une microstructure en mesa selon l'invention. La première étape (I) du procédé PROC4 consiste à mettre en œuvre les étapes du procédé de fabrication PROC1 selon le premier mode de réalisation de l'invention ou le procédé PROC2 selon le deuxième mode de réalisation de l'invention pour fabriquer une microstructure en mésa 10 selon l'invention. Dans ce cas, une microstructure en mesa ayant une jonction P-N horizontale J1 est obtenue.

La deuxième étape (II) consiste à déposer au moins une première électrode sur la microstructure en mésa 10. Lorsque le composant fabriqué est une diode, la deuxième étape (II) consiste à déposer une couche métallique faisant office d'anode An sur la face apparente de la microstructure en mesa 10. Lorsque le composant fabriqué est un transistor Tr, la deuxième étape (II) consiste à doper la surface supérieure de la microstructure en mesa avec des dopants N pour créer au moins une source S1, et fabriquer une grille G1. De manière préférentielle, la grille G1 est disposée au centre de la microstructure en mesa 10 et deux sources sont disposées de part et d'autre de manière symétrique par rapport à la grille G1. Selon un aspect particulier de l'invention, la deuxième étape (II) comprend la fabrication d'une pluralité de grilles sur un mesa.

La troisième étape (III) consiste à réaliser au moins une cavité dans l'une quelconque des structures d'isolation 13a, 13b. Dans l'exemple illustratif, deux cavités 21a, 21b sont réalisées respectivement dans la première structure d'isolation 13a et la deuxième structure d'isolation 13b. Chaque cavité 21a, 21b débouche jusqu'au substrat de croissance 9. Les cavités 21a, 21b sont réalisées par gravure humide ou sèche.

La quatrième étape (VI) consiste à déposer une deuxième électrode dans chaque cavité 21a, 21b. Lorsque le composant fabriqué est une diode, la quatrième étape (VI) consiste à déposer une couche métallique faisant office de cathode Ct en contact avec le substrat de croissance 9 dans la cavité 21a et/ou 21b. Lorsque le composant fabriqué est un transistor Tr, la quatrième étape (VI) consiste à déposer une couche métallique faisant office de drain D1 en contact avec le substrat de croissance 9 dans la cavité 21a et/ou 21b.

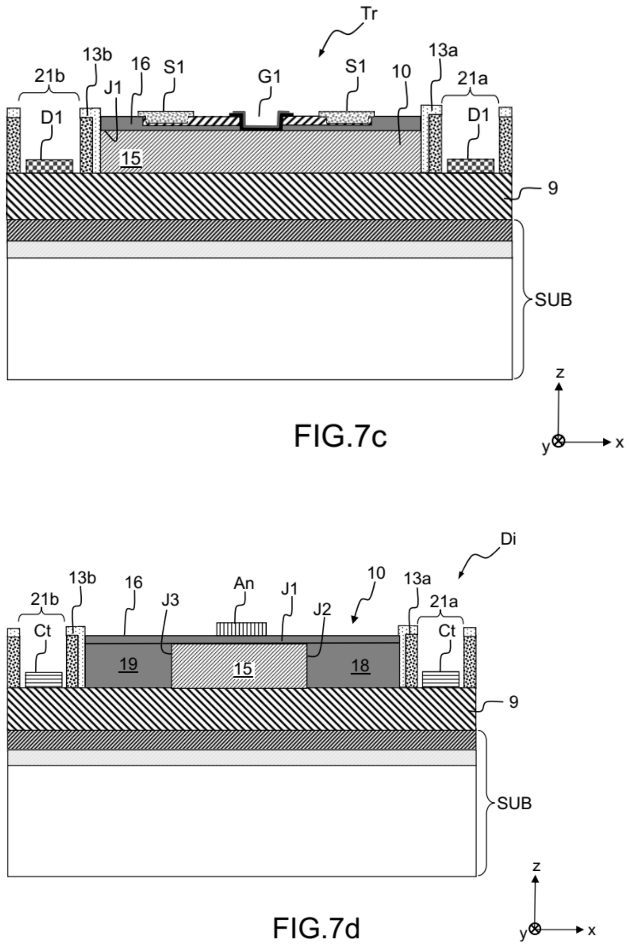

La figure 7b illustre une vue en coupe d'une diode Di « quasi-verticale » obtenue par le procédé de fabrication PROC4 selon l'invention. On entend par « quasi-verticale », le fait qu'une électrode inférieure ne soit pas entièrement située sous la surface inférieure de la microstructure en mesa, mais que l'électrode inférieure ait sa surface inférieure alignée horizontalement avec la surface inférieure de la microstructure en mesa. La figure 7c illustre une vue en coupe d'un transistor Tr de puissance « quasi-vertical » obtenu par le procédé de fabrication PROC4 selon l'invention. A titre illustratif non limitatif, le substrat de croissance 9 en GaN est disposé sur un support SUB formé par un empilement de couches sur un substrat en silicium. L'utilisation d'un substrat en silicium permet d'intégrer le procédé de fabrication du composant de puissance selon l'invention dans une chaine de production microélectronique de tranchées en silicium.

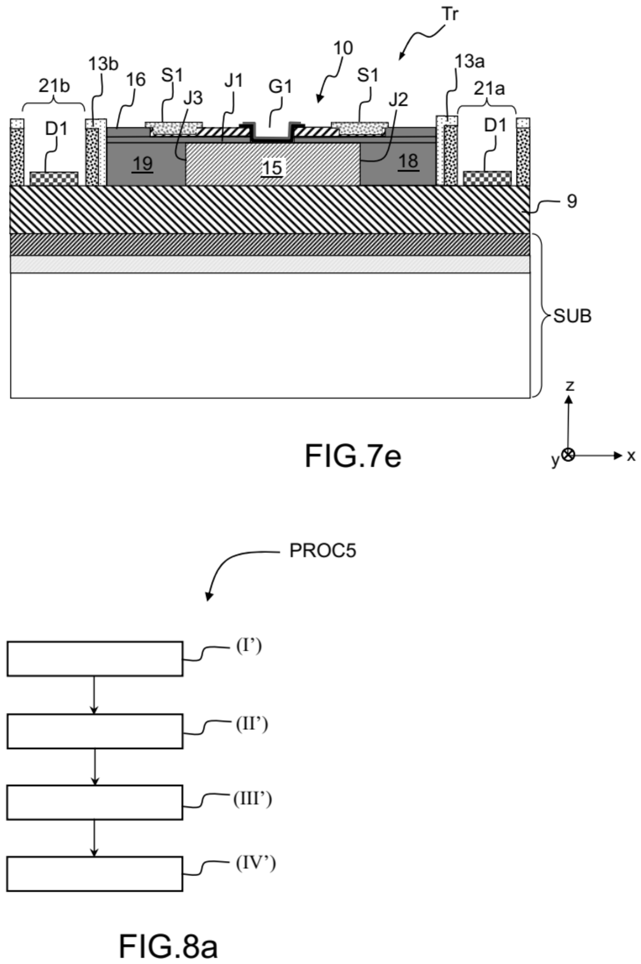

Alternativement, la première étape (I) consiste à mettre en œuvre des étapes du procédé PROC3 selon le troisième mode de réalisation de l'invention. Le procédé PROC4 permet, ainsi, de fabriquer une diode Di avec une microstructure en mesa comprenant trois jonctions P-N J1, J2, J3 comme illustré sur la figure 7d. De manière alternative, le procédé PROC4 permet de fabriquer un transistor « quasi-vertical » Tr avec une microstructure en mesa comprenant trois jonctions P-N J1, J2, J3 comme illustré sur la figure 7e.

La figure 8a illustre l'organigramme d'un second procédé de fabrication PROC5 d'un composant de puissance selon l'invention. Le composant de puissance peut être une diode ou un transistor de puissance. Le composant de puissance comprend une zone active formée dans une microstructure en mesa selon l'invention. La première étape (I') du procédé PROC5 consiste à mettre en œuvre les étapes du procédé de fabrication PROC1 selon le premier mode de réalisation de l'invention ou le procédé PROC2 selon le deuxième mode de réalisation de l'invention pour fabriquer une microstructure en mésa 10 selon l'invention. Dans ce cas, une microstructure en mesa ayant une jonction P-N horizontale est obtenue. Dans le procédé PROC5, le substrat de croissance 9 en GaN est disposé sur un support SUB formé par un empilement de couches sur un substrat en silicium.

La deuxième étape (II') consiste à déposer au moins une première électrode sur la microstructure en mésa 10. De manière identique à la deuxième étape (II) du procédé PROC4.

La troisième étape (III') consiste à retirer le support SUB de manière à découvrir une deuxième face du substrat de croissance 9 opposée à la première face sur laquelle est disposée la microstructure en mesa 10. Cette étape est réalisée par une opération d'amincissement du substrat en silicium par polissage abrasif suivie d'une opération de gravure sèche ou humide. Durant cette étape, le confinement de la microstructure en mesa entre les structures d'isolations permet de protéger le composant fabriqué sans avoir recours à une étape de remplissage par un diélectrique. Le procédé de fabrication selon l'invention comprend ainsi moins d'étapes par rapport aux solutions connues.

La quatrième étape (IV') consiste à déposer une couche conductrice sur ladite deuxième face faisant office de cathode dans le cas d'une diode et de drain dans le cas d'un transistor.

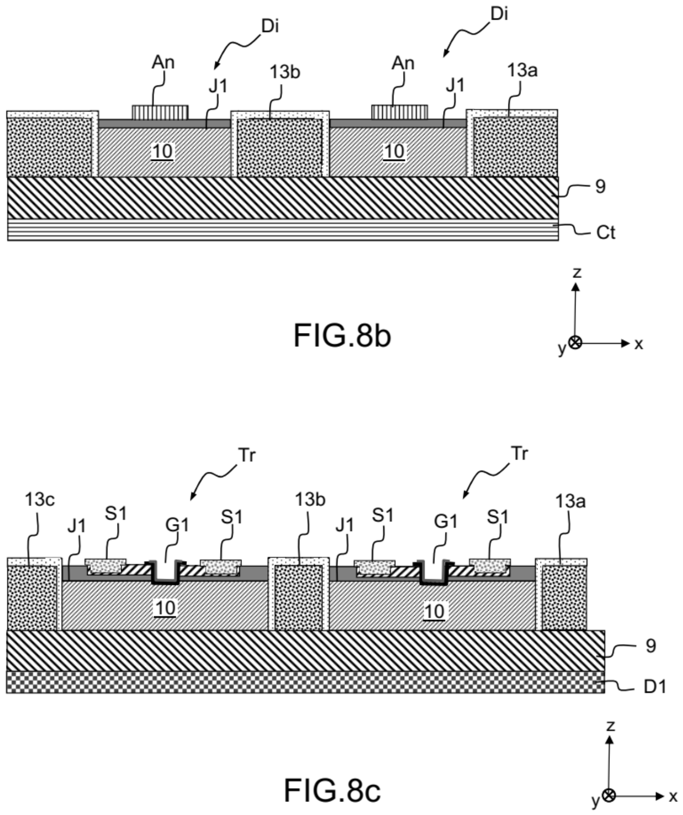

La figure 8b illustre une vue en coupe d'une diode Di verticale obtenue par le procédé de fabrication PROC5 selon de l'invention. La figure 8c illustre une vue en coupe d'un transistor Tr de puissance vertical obtenu par le procédé de fabrication PROC5 selon l'invention.

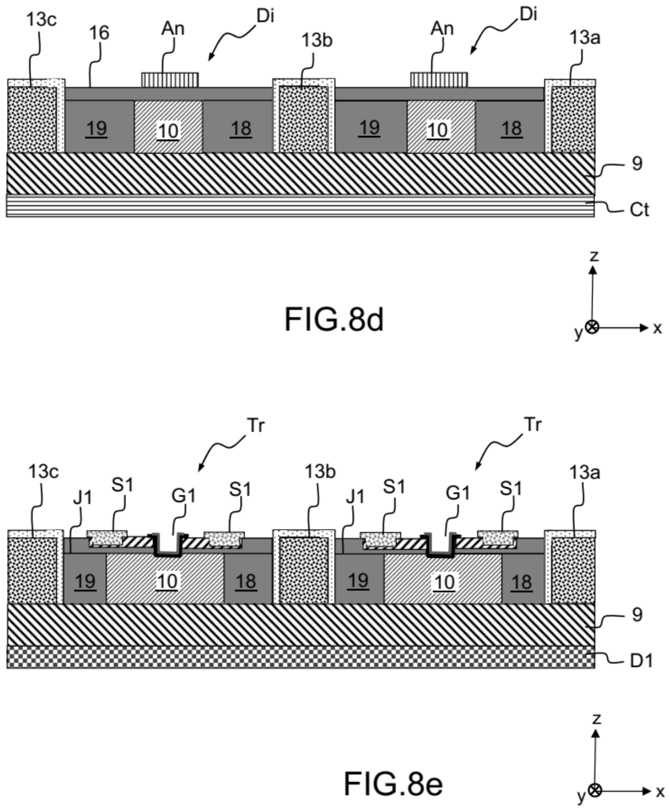

Alternativement, la première étape (I') consiste à la mise en œuvre des étapes du procédé PROC3 selon le troisième mode de réalisation de l'invention. Le procédé PROC5 permet, ainsi, de fabriquer une diode Di verticale avec une microstructure en mesa comprenant trois jonctions P-N J1, J2, J3 comme illustré sur la figure 8d. De manière alternative, Le procédé PROC5 permet de fabriquer un transistor vertical Tr avec une microstructure en mesa comprenant trois jonctions P-N J1, J2, J3 comme illustré sur la figure 8e.

## Revendications

1. Procédé de fabrication (PROC1, PROC2, PROC3) d'une microstructure en mésa (10) disposée sur une face d'un substrat de croissance (9), le substrat de croissance (9) étant réalisé en un premier matériau semi-conducteur qui s'étend selon un plan de substrat (X,Y) ; le procédé comprenant les étapes suivantes :
**i)** déposer une couche d'isolation (11), en un diélectrique, sur le substrat de croissance (9) ;
**ii)** fabriquer une première (13a) et une deuxième structure d'isolation (13b) séparées l'une de l'autre par une ouverture (14) dans laquelle le substrat de croissance (9) est découvert; chaque structure d'isolation (13a, 13b) comprenant un corps (131a, 131b) formé par un volume non-gravé de la couche d'isolation (11) et une enveloppe (132a, 132b) barrière aux atomes de silicium enrobant ledit corps (131a, 131b); les parois latérales de chaque structure d'isolation s'étendent selon un plan (P1) ayant un angle (θ) par rapport audit plan de substrat (X,Y) compris entre 80° et 100° ;
**iii)** faire croitre ladite microstructure en mésa (10), en ledit premier matériau semi-conducteur, par épitaxie localisée dans l'ouverture (14) à partir du substrat de croissance (9) tel que la microstructure en mésa (10) soit confinée entre les deux structures d'isolation (13a, 13b) avec des parois latérales adhérant à celles des structures d'isolation (13a, 13b).

2. Procédé de fabrication (PROC1, PROC2, PROC3) d'une microstructure en mésa (10) selon la revendication 1 dans lequel le premier matériau semi-conducteur est choisi parmi le nitrure de gallium GaN ou le nitrure d'aluminium-gallium AlGaN ou le nitrure d'aluminium AIN.

3. Procédé de fabrication (PROC1, PROC2, PROC3) d'une microstructure en mésa (10) selon l'une quelconque des revendications 1 ou 2 dans lequel le diélectrique de la couche d'isolation (11) est le SiO₂.

4. Procédé de fabrication (PROC1, PROC2, PROC3) d'une microstructure en mésa (10) selon l'une quelconque des revendications 1 à 3 dans lequel l'étape de croissance (iii) est configurée de sorte que l'épaisseur de la microstructure en mésa (10) soit inférieure à celle des deux structures d'isolation associées, l'épaisseur étant mesurée selon une direction perpendiculaire au plan de substrat (X,Y).

5. Procédé de fabrication (PROC1, PROC3) d'une microstructure en mésa (10) selon l'une quelconque des revendications 1 à 4 dans lequel l'étape de fabrication (ii) comprend les sous-étapes suivantes :
**ii.1)** déposer une première couche barrière (132) aux atomes de silicium sur la couche d'isolation (11) ;
**ii.2)** graver la première couche barrière (132) et la couche d'isolation (11) de manière à fabriquer l'ouverture (14) délimitée par deux corps (131a, 131b) correspondant à des volumes non-gravés de la couche d'isolation ;
**ii.3)** déposer une deuxième couche barrière (132') aux atomes de silicium sur les parois latérales desdits corps (131a, 131b) et sur le substrat de croissance (9) découvert dans l'ouverture (14) ;
**ii.4)** retirer la partie de la deuxième couche barrière (132') située sur le substrat de croissance (9) découvert dans l'ouverture (14) par gravure de manière à découvrir le substrat de croissance (9) dans l'ouverture.

6. Procédé de fabrication (PROC2, PROC3) d'une microstructure en mésa (10) selon l'une quelconque des revendications 1 à 4 dans lequel l'étape de fabrication (ii) comprend les sous-étapes suivantes :
**ii.1')** graver la couche d'isolation (11) de manière à fabriquer l'ouverture (14) délimitée par deux corps (131a, 131b) correspondant à des volumes non-gravés de la couche d'isolation ;
**ii.2')** déposer une couche barrière (132) aux atomes de silicium sur les parois supérieures et latérales desdits corps (131a, 131b) et sur le substrat de croissance (9) découvert dans l'ouverture (14) ;
**ii.3')** retirer la partie de couche barrière (132) située sur le substrat de croissance (9) découvert dans l'ouverture (14) par gravure de manière à découvrir le substrat de croissance (9) dans l'ouverture.

7. Procédé de fabrication (PROC1, PROC2, PROC3) d'une microstructure en mésa (10) selon l'une quelconque des revendications 1 à 6 dans lequel l'étape de croissance (iii) comprend la sous-étape suivante :
**iii.1** faire croitre une couche principale (15) en le premier matériau semi-conducteur par épitaxie localisée dans l'ouverture (14) à partir du substrat de croissance (9) ; une concentration volumique des dopants dans la couche principale (15) étant inférieure à celle dans le substrat de croissance (9).

8. Procédé de fabrication (PROC1, PROC2) d'une microstructure en mésa (10) selon la revendication 7 dans lequel, le premier matériau semi-conducteur de la couche principale (15) est dopé N, et l'étape de croissance (iii) comprend en outre la sous-étape suivante :
**iii.2** faire croitre une couche secondaire (16) en le premier matériau semi-conducteur dopé P par épitaxie localisée dans l'ouverture (14) sur la couche principale (15) pour réaliser une jonction P-N horizontale (J1) qui s'étend parallèlement au plan de substrat (X,Y).

9. Procédé de fabrication (PROC3) d'une microstructure en mésa (10) selon la revendication 7, dans lequel le premier matériau semi-conducteur de la couche principale (15) est dopé N, et le procédé de fabrication d'une microstructure en mésa (10) comprenant en outre les étapes suivantes :
**iv)** graver partiellement la première structure d'isolation (13a) de manière à réaliser une ouverture supplémentaire (17a) délimitée par la partie non gravée de la première structure d'isolation (13a) et la microstructure en mésa (10) ; et graver partiellement la deuxième structure d'isolation (13b) de manière à réaliser une ouverture additionnelle (17b) délimitée par la partie non gravée de la deuxième structure d'isolation (13b) et la microstructure en mésa (10) ;
**v)** enrober les parois de la partie non gravée de la première structure d'isolation (13a) et les parois de la partie non gravée de la deuxième structure d'isolation (13b) par une enveloppe barrière aux atomes de silicium ;
**vi)** faire croitre une couche secondaire (18) en le premier matériau semi-conducteur dopé P par épitaxie localisée dans l'ouverture supplémentaire (17a) à partir du substrat de croissance (9) pour réaliser une première jonction P-N latérale (J2) qui s'étend le long d'un axe orthogonal au plan de substrat (X,Y) ; et faire croitre une couche tertiaire (19) en le premier matériau semi-conducteur dopé P par épitaxie localisée dans l'ouverture additionnelle (17b) à partir du substrat de croissance (9) pour réaliser une deuxième jonction P-N latérale (J3) qui s'étend le long d'un axe orthogonal au plan de substrat (X,Y).

10. Procédé de fabrication (PROC3) d'une microstructure en mésa (10) selon la revendication 9, comprenant en outre l'étape suivante :
**vii)** faire croitre une couche quaternaire (20) en le premier matériau semi-conducteur dopé P par épitaxie localisée sur la couche principale (15), la couche secondaire (18) et la couche tertiaire (19) pour réaliser une jonction P-N horizontale (J1) qui s'étend parallèlement au plan de substrat (X,Y).

11. Procédé de fabrication (PROC4) d'un composant électronique de puissance (Di,Tr) comprenant une zone active (ZA) réalisée dans une microstructure en mésa (10) sur un substrat de croissance (9) comprenant au moins une jonction P-N (J1) qui s'étend parallèlement au plan de substrat (X,Y) ; le procédé de fabrication (PROC4) comprenant les étapes suivantes :
**I)** mettre en œuvre les étapes du procédé de fabrication (PROC1, PROC2, PROC3) d'une microstructure en mésa (10) selon l'une quelconque des revendications 1 à 10 ;
**II)** déposer au moins une première électrode (An, S1) sur la microstructure en mésa (10) ;
**III)** réaliser une cavité (21a, 21b) dans l'une quelconque desdites structures d'isolation (13a, 13b) débouchant jusqu'au substrat de croissance (9) par gravure ;
**IV)** déposer une deuxième électrode (Ct, D1) dans la cavité (21a, 21b).

12. Procédé de fabrication (PROC5) d'un composant électronique de puissance (Di,Tr) comprenant une zone active (ZA) réalisée dans une microstructure en mésa (10) sur une première face d'un substrat de croissance (9) comprenant au moins une jonction P-N (J1) qui s'étend parallèlement au plan de substrat (X,Y) ; le procédé de fabrication (PROC4) comprenant les étapes suivantes :
**I')** mettre en œuvre les étapes du procédé de fabrication (PROC1, PROC2, PROC3) d'une microstructure en mésa (10) selon l'une quelconque des revendications 1 à 10 ; le substrat de croissance (9) étant disposé sur un empilement de couches formant un support (SUB) ;
**II')** déposer au moins une première électrode (An, S1) sur la microstructure en mésa (10) ;
**III')** retirer le support (SUB) de manière à découvrir une deuxième face du substrat de croissance (9) opposée à la première face ;
**IV')** déposer une deuxième électrode (Ct, D1) sur la deuxième face du substrat de croissance (9).

13. Composant électronique de puissance (Di, Tr) comprenant :
- une microstructure en mésa (10) disposée sur une face d'un substrat de croissance (9) en un premier matériau semi-conducteur qui s'étend selon un plan de substrat (X,Y) ; la microstructure en mésa (10) étant réalisée en ledit premier matériau semi-conducteur ;
- une première structure d'isolation (13a) et une deuxième structure d'isolation (13b); chaque structure d'isolation (13a, 13b) comprenant :
o un corps (131a, 131b) en un diélectrique ;
o et une enveloppe (132a, 132b) barrière aux atomes de silicium enrobant ledit corps (131a, 131b) ;
la première (13a) et la deuxième structure d'isolation (13b) étant séparées l'une de l'autre par une ouverture (14) dans laquelle le substrat de croissance (9) est découvert, et la microstructure en mésa (10) étant réalisée par épitaxie localisée dans l'ouverture (14) à partir du substrat de croissance (9) tel que la microstructure en mésa (10) est confinée entre les deux structures d'isolation (13a, 13b) avec des parois latérales adhérant à celle des structures d'isolation (13a, 13b) ; les parois latérales de chacune des structures d'isolation (13a, 13b) (10) s'étendant selon un plan (P1) ayant un angle (θ) par rapport audit plan de substrat (X,Y) compris entre 80° et 100°.

14. Composant électronique de puissance (Di, Tr) selon la revendication 13 dans lequel la microstructure en mésa (10) comprend :
∘ une première couche (15) en le premier matériau semi-conducteur dopée N disposée sur le substrat de croissance (9) ;
∘ une deuxième couche (16) en le premier matériau semi-conducteur dopée P disposée sur la première couche (15) de manière à former une jonction P-N horizontale (J1) qui s'étend parallèlement au plan de substrat (X,Y).

15. Composant électronique de puissance (Di, Tr) selon la revendication 13 dans lequel la microstructure en mésa (10) comprend :
∘ une première couche (15) en le premier matériau semi-conducteur dopée N disposée sur le substrat de croissance (9) ;
∘ une deuxième couche (18) en le premier matériau semi-conducteur dopé P disposée sur substrat de croissance (9) et confinée entre la première structure d'isolation (13a) et la première couche (15) de manière à réaliser une première jonction P-N latérale (J2) qui s'étend le long d'un axe orthogonal au plan de substrat (X,Y) ;
∘ une troisième couche (19) en le premier matériau semi-conducteur dopé P sur le substrat de croissance (9) et confinée entre la deuxième structure d'isolation (13b) et la première couche (15) de manière à réaliser une deuxième jonction P-N latérale (J3) qui s'étend le long d'un axe orthogonal au plan de substrat (X,Y) ;
∘ une quatrième couche (20) en le premier matériau semi-conducteur dopée P disposée sur au moins la première couche (15) de manière à former une jonction P-N horizontale (J1) qui s'étend parallèlement au plan de substrat (X,Y).
